# EUROPEAN PATENT APPLICATION

(11) **EP 4 641 932 A1**
(43) Date of publication of application: **29.10.2025**
(21) Application number: 25171371.5
(22) Date of filing: 17.04.2025
(51) Int. Cl.: H03M 1/46

(54) **SAR ADC WITH DIRECT DECISION FEEDBACK LOOP**

(30) Priority: 22.04.2024 US 202463637124 P; 08.04.2025 US 202519173211
(71) Applicant: Analog Devices, Inc., Wilmington, MA 01887 (US)
(72) Inventor: Shen, Junhua, Wilmington, 01887 (US); Chen, Wei-Hung, Wilmington, 01887 (US); Kapusta, Ronald, Wilmington, 01887 (US)
(74) Representative: Wallin, Nicholas James

(57) **Abstract**

Successive approximation register (SAR) analog-to-digital converters (ADCs) with direct decision feedback loops are disclosed herein. In certain embodiments, a SAR ADC includes a digital-to-analog converter (DAC) that generates an analog output signal, a comparator including an input that receives the analog output signal of the DAC and an output that generates a comparison signal, and an array of switches coupled to the output of the comparator and operable to provide a non-latched feedback signal to a digital input of the DAC.

## Description

### Field of the Disclosure

Embodiments of the invention relate to electronics, and more particularly to successive approximation register (SAR) analog-to-digital converters (ADCs).

### BACKGROUND

SAR ADCs are a type of data converter that successively approximates an analog input voltage. For example, the analog input voltage of a SAR ADC can be held on a track-and-hold (T/H) circuit and compared to an output voltage of a digital-to-analog converter (DAC). Additionally, a control circuit implementing a search algorithm (for example, a binary search algorithm) controls the digital input code of the DAC bit-by-bit to determine an N-bit digital word corresponding to a digital representation of the analog input voltage.

By providing data conversion in this manner, low power consumption and a compact form factor can be achieved. SAR ADCs are frequently the architecture of choice for medium-to-high-resolution applications such as those associated with portable/battery-powered instruments, pen digitizers, industrial controls, and/or data/signal acquisition.

### SUMMARY OF THE DISCLOSURE

In one aspect, a successive approximation register analog-to-digital converter (SAR ADC) is disclosed. The SAR ADC includes a digital-to-analog converter (DAC) configured to generate an analog output signal, a comparator including an input configured to receive the analog output signal of the DAC and an output configured to generate a comparison signal, and an array of switches coupled to the output of the comparator and configured to provide a non-latched feedback signal to a digital input of the DAC.

In another aspect, a method of data conversion in a successive approximation register analog-to-digital converter (SAR ADC) is disclosed. The method includes generating an analog output signal using a digital-to-analog converter (DAC), receiving the analog output signal of the DAC as an input to a comparator, outputting a comparison signal from an output of the comparator, and providing a non-latched feedback signal to a digital input of the DAC using an array of switches coupled to the output of the comparator

### BRIEF DESCRIPTION OF THE DRAWINGS

Figure 1 is a schematic diagram of one example of a SAR ADC.
Figure 2 is a schematic diagram of a SAR ADC according to one embodiment.
Figure 3 is one example of a timing diagram for a SAR ADC using direct decision feedback.
Figure 4A is a schematic diagram of a portion of a SAR ADC according to another embodiment.
Figure 4B is one example of a timing diagram for a bitlatch unit of Figure 4A.
Figure 5A is a schematic diagram of a switch select circuit for a bitlatch unit.
Figure 5B is a graph of one example of a clock signal waveform for the switch select circuit of Figure 5A.
Figure 5C is a graph of one example of select and bit ready signal waveforms for the switch select circuit of Figure 5A.
Figure 6 is a graph of one example of a timing diagram for bitlatch units of a SAR ADC.
Figure 7 is a schematic diagram of one example of a latch for a bitlatch unit of a SAR ADC.
Figure 8 is a schematic diagram of one example of a bit ready circuit for a bitlatch unit of a SAR ADC.

### DETAILED DESCRIPTION OF EMBODIMENTS

The following detailed description of embodiments presents various descriptions of specific embodiments of the invention. However, the invention can be embodied in a multitude of different ways. In this description, reference is made to the drawings where like reference numerals may indicate identical or functionally similar elements. It will be understood that elements illustrated in the figures are not necessarily drawn to scale. Moreover, it will be understood that certain embodiments can include more elements than illustrated in a drawing and/or a subset of the elements illustrated in a drawing. Further, some embodiments can incorporate any suitable combination of features from two or more drawings.

While performing a trial decision, a SAR ADC can latch the output of a comparator. Additionally, the latched output can be provided to a DAC of the SAR ADC to provide trial decision feedback.

By providing trial decision feedback in this manner, an analog input voltage to the SAR ADC can be successively approximated. However, providing trial decision feedback in this manner provides low conversion speed. For example, such a SAR ADC can suffer from a critical timing path through the latch. Thus, latch regeneration time, a latching clock setup time, and/or other latch delays contribute to the SAR ADC's trial time and thus limit the maximum frequency that the SAR ADC can operate.

SAR ADCs with direct decision feedback loops are disclosed herein. In certain embodiments, a SAR ADC includes a DAC that generates an analog output signal, a comparator including an input that receives the analog output signal of the DAC and an output that generates a comparison signal, and an array of switches coupled to the output of the comparator and operable to provide a non-latched feedback signal to a digital input of the DAC.

By providing direct decision feedback in this manner, the timing performance of the SAR ADC is improved. For example, such a SAR ADC includes a decision feedback loop from the output of the comparator to the input of the DAC that bypasses the SAR ADC's latches. Thus, a shorter critical timing path can be achieved relative to a SAR ADC in which a comparator's output is latched and then provided to a DAC for trial decision feedback.

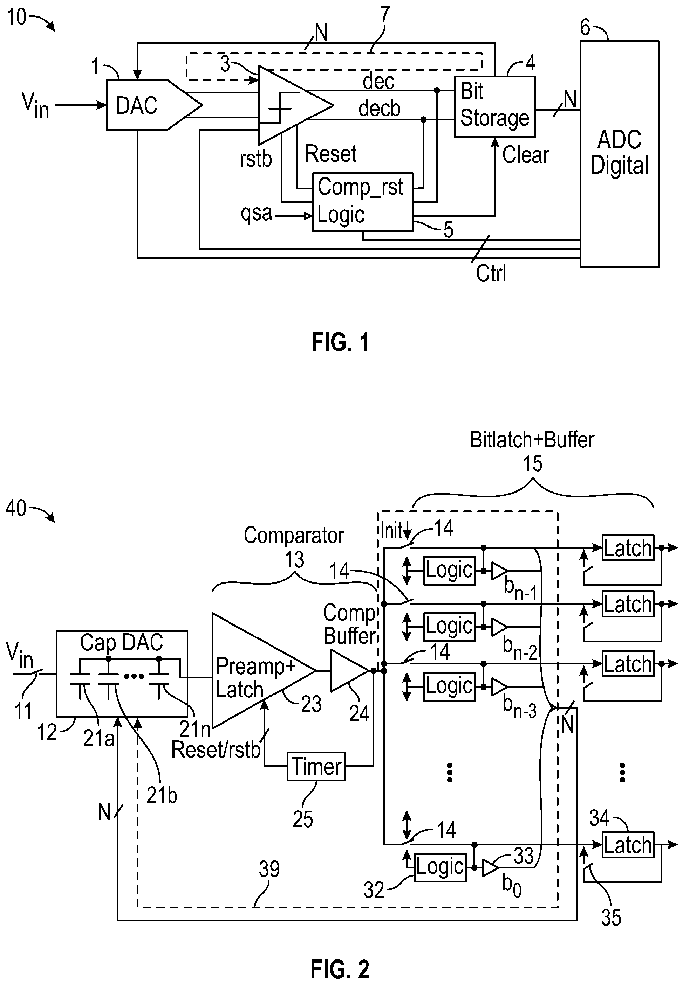

Figure 1 is a schematic diagram of one example of a SAR ADC 10. The SAR ADC 10 includes a DAC 1, a comparator 3, a bit storage circuit 4, a comparator control circuit 5, and an ADC digital circuit 6.

As shown in Figure 1, the SAR ADC 10 receives an analog input signal Vᵢₙ, which is provided to an analog input to the DAC 1. The DAC 1 operates to track-and-hold (T/H) the analog input signal Vᵢₙ to provide a first analog input voltage for the comparator 3. The DAC 1 also receives a digital word with N bits as a feedback input signal. The DAC 1 uses the digital word to generate a second analog input voltage for the comparator 3. The DAC 1 serves to provide trial decision feedback. In certain implementations, the DAC 1 is implemented as a capacitive DAC.

With continuing reference to Figure 1, the comparator 3 compares the first analog input voltage to the second analog input voltage to generate decision signals dec/decb that indicate a result of the comparison performed by the comparator 3.

The decision signals dec/decb are used to generate the N-bit digital word for the DAC 1. The decision signals dec/decb are also latched by the bit storage circuit 4.

With continuing reference to Figure 1, a clock signal qsa initiates the T/H (track-and-hold) and begins the first bit trial (most significant bit or MSB of the N-bit digital word) after the T/H. The SAR ADC 10 thereafter successively resolves the remaining bits of the N-bit digital word.

The SAR ADC 10 also includes the ADC digital circuit 6, which receives the N-bit digital word and generates control signals (Ctrl) for providing various control operations of the SAR ADC 10.

A critical timing path of the SAR ADC 10 can correspond to a decision feedback loop 7. For example, the decision feedback loop 7 can include the comparator 3, the bit storage 4, and the DAC 1 for trial decision feedback.

In one example, for each quantization step to complete a SAR bit trial three events can occur. First, the comparator 3 is launched and used to resolve the decision signals dec/decb. Second, the result of the decision is stored (for instance, latched) into the bit storage circuit 4. Third, the result is passed to the feedback input of the DAC 1, which settles before the next comparison starts. The remaining trials (non-MSB) are initiated by the comparator control circuit 5, which can serve as asynchronous comparator reset logic. The comparator control circuit 5 orchestrates the three events of each SAR bit trial and generates comparator reset and reset release (rstb) signals for the comparator 3. The comparator control circuit 5 can also be used to selectively clear the bit storage circuit 4.

By providing trial decision feedback in this manner, the analog input voltage Vᵢₙ to the SAR ADC 10 can be successively approximated. However, providing trial decision feedback in this manner provides low conversion speed due to a critical timing path through the bit storage circuit 4 that can include latch regeneration time, a latching clock setup time, and/or other latch delays.

Aspects of the disclosure relate to providing direct decision feedback to enhance the performance of SAR ADCs, such as SAR ADC 10. Such direct decision feedback uses a decision feedback loop between the output of a comparator and an input of a DAC that bypasses the SAR ADC's latches. Thus, a shorter critical timing path can be achieved relative to a SAR ADC in which a comparator's output is latched and then provided to a DAC for trial decision feedback.

Figure 2 is a schematic diagram of a SAR ADC 40 according to one embodiment. The SAR ADC 40 includes a T/H switch 11, a capacitive DAC 12 (including an array of capacitors 21a, 21b, ... 21n), a comparator 13, an array of switches 14, and a bitlatch and buffer (bitlatch+buffer) circuit 15.

In the illustrated embodiment, the analog input signal Vᵢₙ is sampled onto one or more of the capacitors 21a, 21b, ... 21n, which can be weighted. Such sampling can include bottom plate sampling or top plate sampling. The capacitive DAC 12 can operate as a switched capacitor circuit suitable for comparing the sampled input voltage to a desired reference voltage. Additionally, the active capacitors are controlled by the N-bit digital word N that serves as a non-latched feedback signal to the capacitive DAC 12. The N-bit digital word includes N bits b₀ ... bₙ₋₃, bₙ₋₂, bₙ₋₁, where bit bₙ₋₁ is the MSB and bit b₀ is the least significant bit (LSB). In this embodiment, the non-latched feedback signal is not latched along the feedback path between the output of the comparator 13 and the input to the capacitive DAC 12.

As shown in Figure 2, the comparator 13 includes a preamp and latch (preamp+latch) circuit 23, a comparator buffer 24, and a timer 25 for generating reset/rstb signals for the preamp+latch 23.

In the illustrated embodiment, the bitlatch+buffer 15 includes N paths, with each path being associated with one of the bits of the N-bit digital word for the capacitive DAC 12. As shown in Figure 2, each of the N paths of the bitlatch+buffer 15 includes a buffer 33, a latch 34, a latch feedback switch 35, and bitlatch logic 32.

Each of the N paths of the bitlatch+buffer 15 is connected to the output of the comparator 13 through a corresponding switch of the array of switches 14. Each of the array of switches 14 can be individually activated by an initialization (Init) signal as the SAR ADC 40 performs bit trials. In certain implementations, the bitlatch logic 32 are implemented to relay a select signal token among the N paths to enable a particular path at a given time. Each switch also operates with a switch turn-off signal derived from that switch's output signal.

The SAR ADC 40 includes a decision feedback path 39, which serves as a critical timing path. The decision feedback path 39 includes a path from the output of the comparator 13 through the array of switches 14 and the bitlatch+buffer 15 to the capacitive DAC 12.

As shown in Figure 2, the latches 34 are not along the decision feedback path 39. Rather, the latches 34 have been moved off the critical timing path and only the array of switches 14 and the corresponding buffers 33 are between the output of comparator 13 and the capacitive DAC 12, in this embodiment. Thus, the comparator decision can be passed to the capacitive DAC 12 through the corresponding switch 12 and buffer 33 before the latch 35 turns on and latches the comparator decision.

Thus, the SAR ADC 40 of Figure 2 uses a pass-then-latch architecture to provide direct decision feedback. Thus, a non-latched feedback signal is provided to the input of the capacitive DAC 12.

By providing direct decision feedback in this manner, the SAR ADC 40 can operate at high speeds, for instance, 12GSPS or more with interleaving of 16 or more units. Furthermore, direction decision feedback allows for the buffer 33 and the latch 34 to be independently optimized and/or otherwise designed. Although an example in which the buffers are included, in other implementations the buffers are omitted.

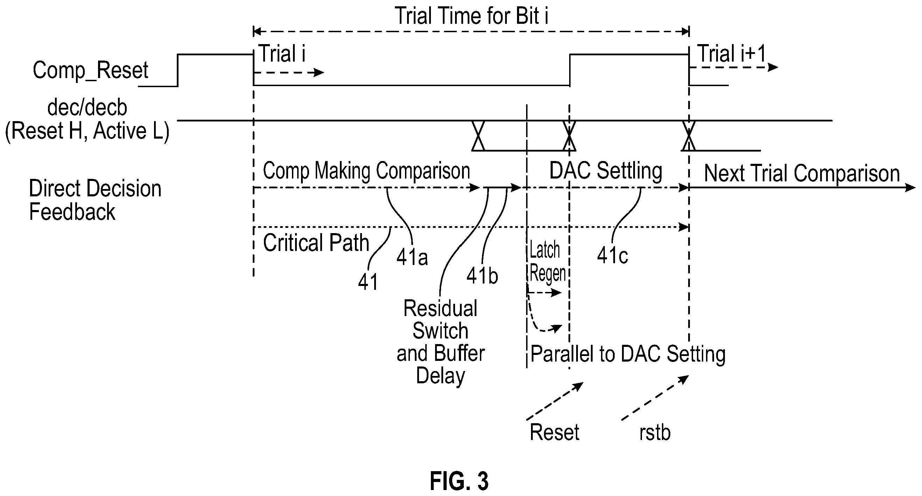

Figure 3 is one example of a timing diagram for a SAR ADC using direct decision feedback. The timing diagram depicts waveforms for a comparator reset signal (comp_reset) and comparator decision signals (dec/decb), which are reset high and active low in this example. The timing diagram depicts an example bit trial (bit trial i).

The SAR ADC includes a critical path 41 associated with direct decision feedback. The critical path includes a comparator comparison delay 41a, a switch and buffer delay 41b through a bitlatch+buffer circuit, and a DAC settling delay 41c. By providing direct decision feedback, the delay through the bitlatch+buffer circuit does not include any delays of latches. Rather, the delay 41b can correspond to that of a delay through a switch (as well as a buffer delay in implementations in which a buffer is included).

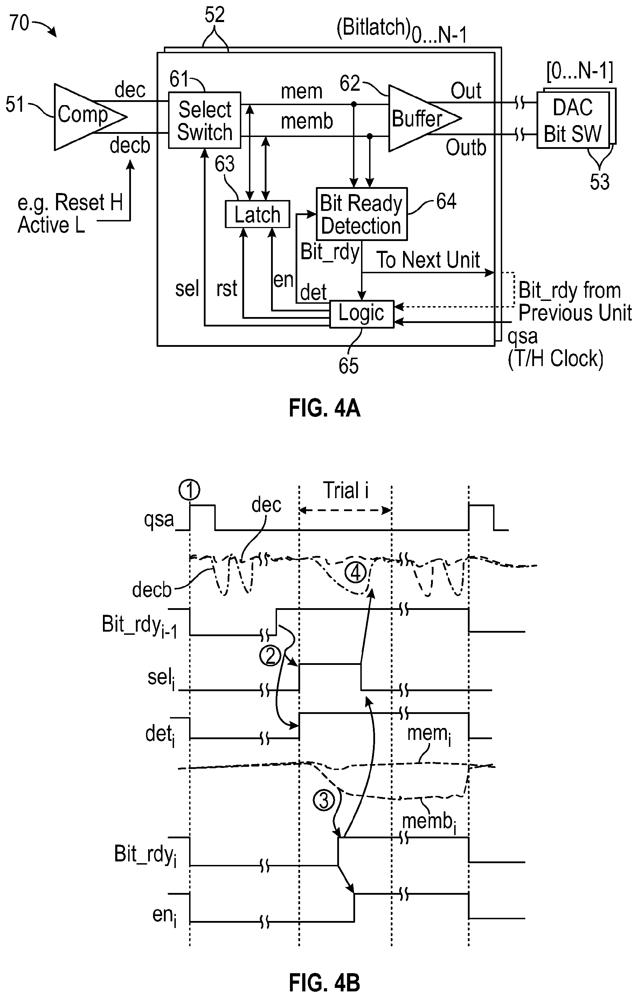

Figure 4A is a schematic diagram of a portion of a SAR ADC 70 according to another embodiment. The SAR ADC circuitry includes a comparator 51, N bitlatch units or slices 52, and N DAC bit switches 53. The depicted SAR ADC circuitry represents one embodiment of circuitry of a SAR ADC along a critical timing path of the SAR ADC.

As shown in Figure 4A, the comparator 51 generates decision signals dec/decb that are provided to the bitlatch units 52. Each bitlatch unit 52 includes a select switch 61, a buffer 62, a latch 63, a bit ready detection circuit 64, and unit logic 65. The unit logic 65 operates using a clock signal qsa that is also used for T/H of the analog input signal to the DAC.

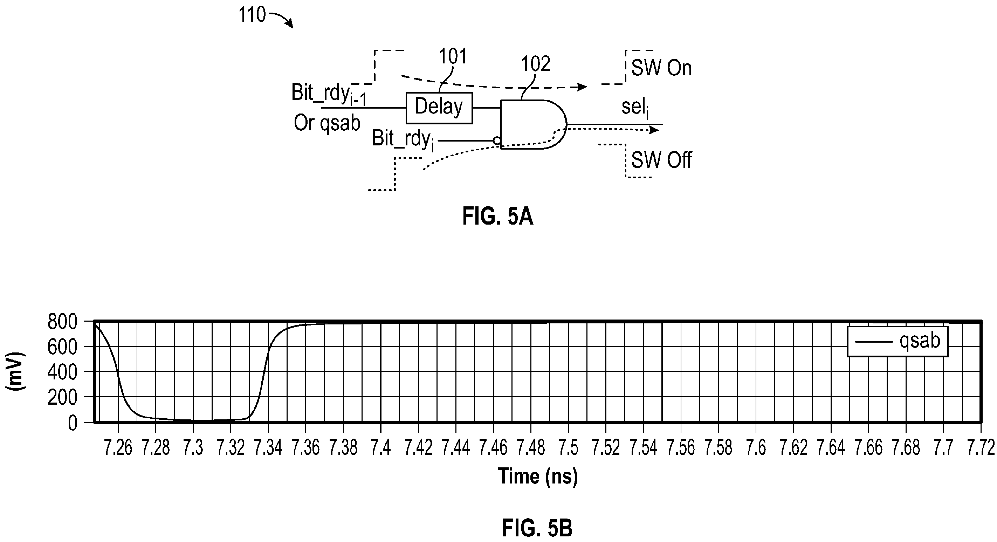

In the illustrated embodiment, the select switch 61 is selectively activated by a select signal (sel) from the unit logic 65. Such a select signal can be generated by a switch select circuit of the unit logic 65, such as that described below with reference to Figure 5A. The unit logic 65 activates a given bitlatch unit 52 when the bitlatch unit 52 is being used to resolve the value for a particular bit of the N-bit digital word for the DAC. When activated, the select switch 61 loads the decision signals dec/decb onto memory nodes mem/memb of the bitlatch unit 52. Additionally, the buffer 62 buffers the signals of the memory nodes mem/memb to generate the output signals out/outb of the bitlatch unit 52. The unit logic 65 also provides a switch turn-off signal that is derived from the output of the select switch 61.

With continuing reference to Figure 4A, the latch 63 is used to latch the signal values of the memory nodes mem/memb. The unit logic 65 controls reset (rst) and enable (en) of the latch 63. In certain implementations, the unit logic 65 only enables the latch 63 after the output of the comparator 51 has been passed through to the buffers 62. By implementing the bitlatch units 52 in this manner, enhanced speed is achieved.

In the illustrated embodiment, the bit ready detection circuit 64 is activated by a detection signal (det) from the unit logic 65. When activated, the bit ready detection circuit 64 determines when the bitlatch unit 52 has resolved the bit. The bit ready detection circuit 64 generates a bit ready signal (Bit_rdy) that is provided to the unit logic 65 of the next bitlatch unit 52. Thus, the unit logic 65 receives the bit ready signal from the previously bitlatch unit 52. Such bit ready signals aid in coordinating operation amongst the bitlatch units 52.

Figure 4B is one example of a timing diagram for a bitlatch unit 52 of Figure 4A. The timing diagram includes waveforms for the clock signal qsa, the comparator decision signals dec/decb, a bit ready signal (bit_rdyᵢ₋₁) from an adjacent bitlatch unit, a switch select signal (selᵢ) a bit ready detection signal (detᵢ), signals on memory nodes (memᵢ/membᵢ), a bit ready signal (bit_rdyᵢ) outputted from the bitlatch unit, and an enable signal enᵢ for a latch of the bitlatch unit.

In this example, all bitlatch units 52 are first reset upon T/H of an analog input signal.

Secondly, the bitlatch unit 52 exits reset after receiving the bit ready signal (bit_rdyᵢ₋₁) from the previous unit. After reset, the select switch and the bit ready detection circuit for the bitlatch unit 52 turn on using the switch select signal (selᵢ) and the bit ready detection signal (detᵢ).

As shown in Figure 4B, after voltage transition on the memory signals mem/memb is detected, the bit ready signal (bit_rdyᵢ) is activated and the memory nodes mem/memb regenerate to full high and low values. Additionally, the select switch turns off and the bit ready signal (bit_rdyᵢ) is activated to move onto to the next unit.

With continuing reference to Figure 4B, lastly the comparator outputs reset after the select switch of the bitlatch unit turns off.

Figure 5A is a schematic diagram of a switch select circuit 110 for a bitlatch unit. For example, when implemented in the bitlatch unit 52 of Figure 4A, the switch select circuit 110 can represent a portion of the unit logic 65 used for activating or deactivating the select switch 61.

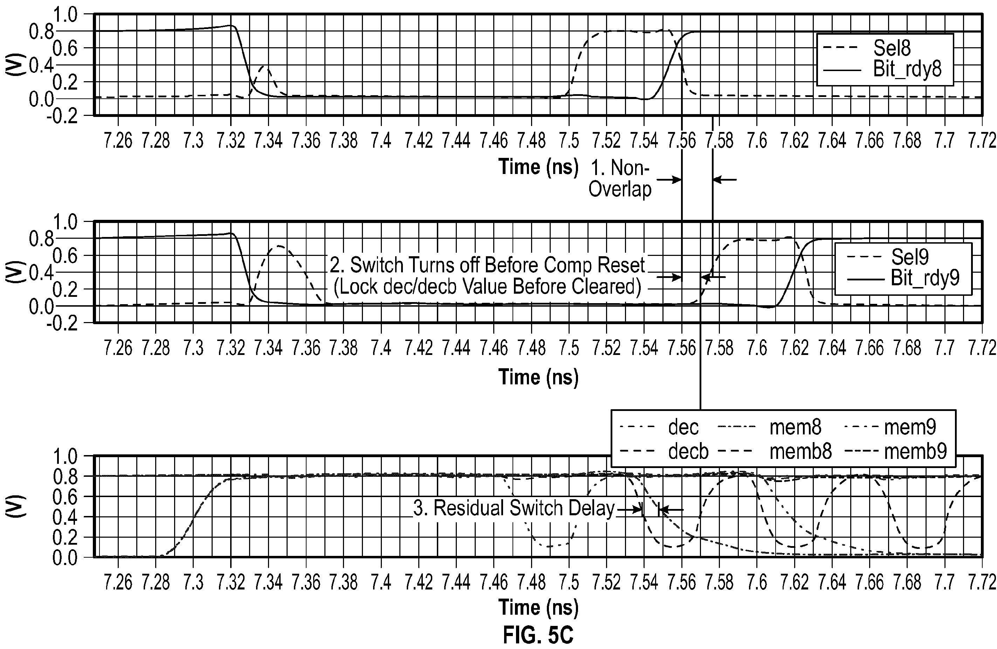

In the illustrated embodiment, the switch select circuit 110 includes a delay circuit 101 and a logic gate 102 (providing AND functionality of a first input and an inverted second input). The delay circuit 101 receives either a bit ready signal from a prior unit (Bit_rdyᵢ₋₁) or an inverted clock signal (qsab) for the first unit. Figure 5B is a graph of one example of a clock signal waveform (corresponding to inverted clock signal or qsab) for the switch select circuit 110 of Figure 5A. The output of the delay circuit 101 is provided to the first input of the logic gate 102. The logic gate receives the bit ready signal of the current unit (Bit_rdyᵢ) as the second input, and outputs a switch selection signal (selᵢ) for activating a select switch (for example, the select switch 61 of Figure 4A) of the bitlatch unit. Figure 5C is a graph of one example of select and bit ready waveforms (Sel8, Bit_rdy8, Sel9, Bit_rdy9, dec/deb, mem8/mem8b, mem9/memb9) for the switch select circuit of Figure 5A.

With reference to Figures 5A to 5C, non-overlap is provided by the delay circuit 101. Thus, the selection switch turns off before the comparator is reset. Providing the non-overlap prevents the wrong value of the comparator output from being stored in a particular bitlatch unit. In the illustrated example, a residual switch delay has also been shown.

In the illustrated embodiment, switch control selection is locally generated using adj acent bit ready signals. This provides quick turn-off with short feedback before comparator reset (also referred to herein as lock-before-clear). The delayed turn-on after previously unit's turn off is to ensure non-overlap (also referred to herein as break before make).

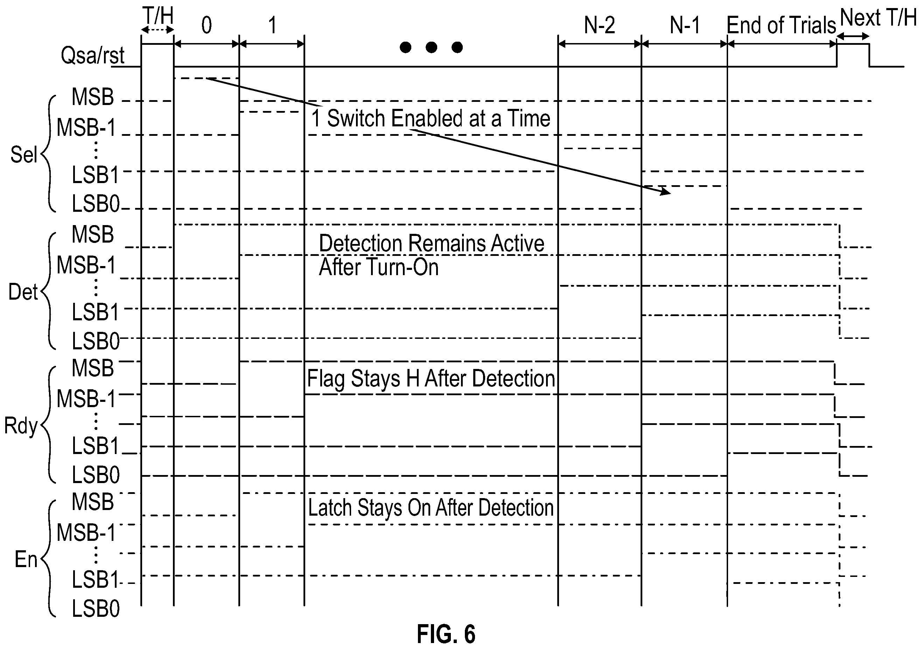

Figure 6 is a graph of one example of a timing diagram for bitlatch units of a SAR ADC. Waveforms for units associated with each bit (ranging from LSB to MSB) are shown. The graph depicts clock and reset (qsa/rst), switch select signals (sel), detection signals (det), bit ready signals (Bit_Rdy or Rdy), and enable signals (en) for example trials.

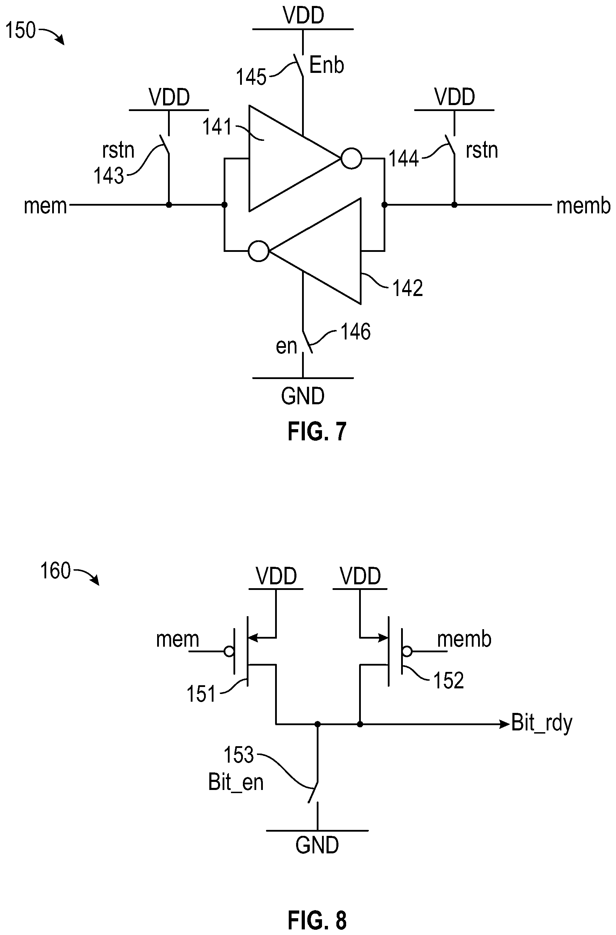

Figure 7 is a schematic diagram of one example of a latch 150 for a bitlatch unit of a SAR ADC. The latch 150 receives power from a power supply voltage VDD and ground GND and includes a first signal node mem and a second signal node memb. The latch 150 includes a first inverter 141, a second inverter 142, a first reset switch 143 (controlled by a reset signal rstn), a second reset switch 144 (controlled by the reset signal rstn), a first enable switch 145 (controlled by an inverted enable signal Enb), and a second enable switch 146 (controlled by an enable signal enb).

The latch 150 depicts one example of a latch with pull-up reset that can be used in a bitlatch unit of a SAR ADC. Although one example of a latch is depicted, any suitable latch circuit can be used in a SAR ADC.

Figure 8 is a schematic diagram of one example of a bit ready circuit 160 for a bitlatch unit of a SAR ADC. The bit ready circuit 160 receives power from a power supply voltage VDD and ground GND and receives memory signals from memory nodes mem/memb. The bit ready circuit 160 generates a bit ready signal (Bit_rdy). The bit ready circuit 160 includes a first p-type metal oxide semiconductor (PMOS) transistor 151, a second PMOS transistor 152, and an enable switch 153. The first signal mem is provided to a gate of the first PMOS transistor 151, while the second signal mem is provided to a gate of the second PMOS transistor 152. The enable switch 153 is controlled by an enable signal (Bit_en).

In the illustrated embodiment, a common-drain node (Bit_rdy) is yanked to VDD when voltage level at nodes mem or memb drops, while the common-drain node (Bit_rdy) is reset to ground by the foot switch 153.

The bit ready circuit 160 depicts one example of a bit ready circuit that can be used in a bitlatch unit of a SAR ADC. However, bit ready circuits can be implemented in other ways.

### Conclusion

The foregoing description may refer to elements or features as being "connected" or "coupled" together. As used herein, unless expressly stated otherwise, "connected" means that one element/feature is directly or indirectly connected to another element/feature, and not necessarily mechanically. Likewise, unless expressly stated otherwise, "coupled" means that one element/feature is directly or indirectly coupled to another element/feature, and not necessarily mechanically. Thus, although the various schematics shown in the figures depict example arrangements of elements and components, additional intervening elements, devices, features, or components may be present in an actual embodiment (assuming that the functionality of the depicted circuits is not adversely affected).

While certain embodiments have been described, these embodiments have been presented by way of example only, and are not intended to limit the scope of the disclosure. Indeed, the novel apparatus, methods, and systems described herein may be embodied in a variety of other forms; furthermore, various omissions, substitutions and changes in the form of the methods and systems described herein may be made without departing from the spirit of the disclosure. For example, while the disclosed embodiments are presented in a given arrangement, alternative embodiments may perform similar functionalities with different components and/or circuit topologies, and some elements may be deleted, moved, added, subdivided, combined, and/or modified. Each of these elements may be implemented in a variety of different ways. Any suitable combination of the elements and acts of the various embodiments described above can be combined to provide further embodiments. Accordingly, the scope of the present invention is defined only by reference to the appended claims.

Although the claims presented here are in single dependency format for filing at the USPTO, it is to be understood that any claim may depend on any preceding claim of the same type except when that is clearly not technically feasible.

There follows a list of numbered features defining particular embodiments of the present disclosure. Where a feature refers to one or more earlier numbered features then those features should be considered together in combination.
1. A successive approximation register analog-to-digital converter (SAR ADC) comprising:
   a digital-to-analog converter (DAC) configured to generate an analog output signal;
   a comparator including an input configured to receive the analog output signal of the DAC and an output configured to generate a comparison signal; and
   an array of switches coupled to the output of the comparator and configured to provide a feedback signal to a digital input of the DAC, wherein no latches are present along a signal path from the output of the comparator to the digital input of the DAC through the array of switches.
2. The SAR ADC of feature 1, wherein each switch of the array of switches includes an input configured to receive the comparison signal and an output, each switch controlled by a corresponding switch turn-off signal derived from the output of the switch.
3. The SAR ADC of feature 1 or 2, further comprising an array of buffers each operable to buffer a corresponding switch of the array of switches.
4. The SAR ADC of feature 1, wherein the array of buffers directly drive the digital input of the DAC with no intervening components.
5. The SAR ADC of any of features 1 to 4, wherein the comparator is reset by a comparator reset clock, the array of switches not controlled by the comparator reset clock.
6. The SAR ADC of feature 4, wherein each switch of the array of switches is controlled by a local bit ready signal that is local to the switch.
7. The SAR ADC of feature 5, further comprising a bit ready detection circuit configured to generate the local bit ready signal based on detecting a signal transition of the switch.
8. The SAR ADC of any of features 1 to7, wherein the comparator comprises a pre-amp with a latch configured to receive the analog output signal of the DAC, and a comparator buffer coupled to an output of the preamp with the latch.
9. The SAR ADC of feature 1, wherein the comparator further comprises a timer coupled to an output of the comparator buffer with the latch and configured to generate a comparator reset clock that resets the preamp.
10. The SAR ADC of any of features 1 to 9, wherein the DAC is a capacitive DAC.
11. The SAR ADC of any of features 1 to 10, further comprising a track and hold (T/H) circuit configured to provide an analog input signal to a reference input of the DAC.
12. A method of data conversion in a successive approximation register analog-to-digital converter (SAR ADC), the method comprising:
   generating an analog output signal using a digital-to-analog converter (DAC);
   receiving the analog output signal of the DAC as an input to a comparator;
   outputting a comparison signal from an output of the comparator; and
   providing a feedback signal to a digital input of the DAC using an array of switches coupled to the output of the comparator, wherein no latches are present along a signal path from the output of the comparator to the digital input of the DAC through the array of switches.
13. The method of feature 8, wherein each switch of the array of switches includes an input receiving the comparison signal and an output, the method further comprising controlling each switch with a corresponding switch turn-off signal derived from the output of the switch.
14. The method of feature 8 or 13, further comprising providing buffering using an array of buffers each operable to buffer a corresponding switch of the array of switches.
15. The method of feature 1, further comprising directly driving the digital input of the DAC using the array of buffers.
16. The method of any of features 8 to 15, further comprising resetting the comparator by a comparator reset clock, the array of switches not controlled by the comparator reset clock.
17. The method of feature 11, further comprising controlling each switch of the array of switches by a local bit ready signal that is local to the switch.
18. The method of feature 1, further comprising a bit ready detection circuit configured to generate the local bit ready signal based on detecting a signal transition of the switch.
19. The method of any of features 11 to 18, wherein the comparator comprises a pre-amp with a latch configured to receive the analog output signal of the DAC and a comparator buffer coupled to an output of the preamp with the latch, the method further comprising using a timer coupled to an output of the comparator buffer and to generate a comparator reset clock that resets the preamp with the latch.
20. The method of any of features 11 to 19, wherein the DAC is a capacitive DAC.
21. The method of any of features 11 to 20, further comprising providing an analog input signal to a reference input of the DAC using a track and hold (T/H) circuit.

## Claims

1. A successive approximation register analog-to-digital converter (SAR ADC) comprising:
a digital-to-analog converter (DAC) configured to generate an analog output signal;
a comparator including an input configured to receive the analog output signal of the DAC and an output configured to generate a comparison signal; and
an array of switches coupled to the output of the comparator and configured to provide a feedback signal to a digital input of the DAC, wherein no latches are present along a signal path from the output of the comparator to the digital input of the DAC through the array of switches.

2. The SAR ADC of Claim 1, wherein each switch of the array of switches includes an input configured to receive the comparison signal and an output, each switch controlled by a corresponding switch turn-off signal derived from the output of the switch.

3. The SAR ADC of Claim 1 or 2, further comprising an array of buffers each operable to buffer a corresponding switch of the array of switches; wherein optionally the array of buffers directly drive the digital input of the DAC with no intervening components.

4. The SAR ADC of any of Claims 1 to 3, wherein the comparator is reset by a comparator reset clock, the array of switches not controlled by the comparator reset clock.

5. The SAR ADC of Claim 4, wherein each switch of the array of switches is controlled by a local bit ready signal that is local to the switch;
the SAR ADC optionally further comprising a bit ready detection circuit configured to generate the local bit ready signal based on detecting a signal transition of the switch.

6. The SAR ADC of any of Claims 1 to 5, wherein the comparator comprises a pre-amp with a latch configured to receive the analog output signal of the DAC, and a comparator buffer coupled to an output of the preamp with the latch;
wherein optionally the comparator further comprises a timer coupled to an output of the comparator buffer with the latch and configured to generate a comparator reset clock that resets the preamp.

7. The SAR ADC of any of Claims 1 to 6, wherein one or more of the following apply:
a) the DAC is a capacitive DAC; and/or
b) the SAR ADC further comprises a track and hold (T/H) circuit configured to provide an analog input signal to a reference input of the DAC.

8. A method of data conversion in a successive approximation register analog-to-digital converter (SAR ADC), the method comprising:
generating an analog output signal using a digital-to-analog converter (DAC);
receiving the analog output signal of the DAC as an input to a comparator;
outputting a comparison signal from an output of the comparator; and
providing a feedback signal to a digital input of the DAC using an array of switches coupled to the output of the comparator, wherein no latches are present along a signal path from the output of the comparator to the digital input of the DAC through the array of switches.

9. The method of Claim 8, wherein each switch of the array of switches includes an input receiving the comparison signal and an output, the method further comprising controlling each switch with a corresponding switch turn-off signal derived from the output of the switch.

10. The method of Claim 8 or 9, further comprising providing buffering using an array of buffers each operable to buffer a corresponding switch of the array of switches; and optionally further comprising directly driving the digital input of the DAC using the array of buffers.

11. The method of any of Claims 8 to 10, further comprising resetting the comparator by a comparator reset clock, the array of switches not controlled by the comparator reset clock.

12. The method of Claim 11, further comprising controlling each switch of the array of switches by a local bit ready signal that is local to the switch; and optionally further comprising a bit ready detection circuit configured to generate the local bit ready signal based on detecting a signal transition of the switch.

13. The method of any of Claims 8 to 12, wherein the comparator comprises a pre-amp with a latch configured to receive the analog output signal of the DAC and a comparator buffer coupled to an output of the preamp with the latch, the method further comprising using a timer coupled to an output of the comparator buffer and to generate a comparator reset clock that resets the preamp with the latch.

14. The method of any of Claims 8 to 13, wherein the DAC is a capacitive DAC.

15. The method of any of Claims 8 to 14, further comprising providing an analog input signal to a reference input of the DAC using a track and hold (T/H) circuit.
